# EUROPÄISCHE PATENTSCHRIFT

(11) **EP 1 092 175 B1**
(45) Veröffentlichungstag und Bekanntmachung des Hinweises auf die Patenterteilung: **16.10.2002**
(21) Anmeldenummer: 99931095.6
(22) Anmeldetag: 17.06.1999
(51) Int. Cl.: G03F 7/20, G02B 5/30

(54) **Beleuchtungssystem der Mikrolithographie mit Depolarisator**
Microlithography illumination system with depolariser
Système d'illumination avec dépolariseur pour la microlithographie

(30) Priorität: 02.07.1998 DE 19829612
(43) Veröffentlichungstag der Anmeldung: 18.04.2001
(73) Patentinhaber: Carl Zeiss, 89518 Heidenheim (Brenz) (DE); CARL ZEISS-STIFTUNG HANDELND ALS CARL ZEISS, D-89518 Heidenheim (Brenz) (DE)
(72) Erfinder: MAUL, Manfred, D-73434 Aalen (DE)
(86) Internationale Anmeldenummer: EP9904212
(87) Internationale Veröffentlichungsnummer: WO00002092

(56) Entgegenhaltungen:
- EP-A- 0 747 772
- EP-A- 0 764 858
- DE-A- 19 637 563
- US-A- 4 370 026
- PATENT ABSTRACTS OF JAPAN vol. 018, no. 221 (E-1540), 20. April 1994 (1994-04-20) -& JP 06 020912 A (NIKON CORP), 28. Januar 1994 (1994-01-28)
- WANG B: 'Birefringence in fused silica and CaF2 for lithography' SOLID STATE TECHNOLOGY Bd. 43, Nr. 2, Februar 2000, WASHINGTON, US, Seiten 77 - 82

## Beschreibung

Die Erfindung betrifft ein Beleuchtungssystem der Mikrolithographie mit einem Excimer-Laser mit einer Emissionswellenlänge, einem Strahlaufweitungssystem, einem Lichtmischsystem und einer Beleuchtungsebene.

Derartige Beleuchtungssysteme sind in der DUV-Mikrolithographie mit 248 nm, 193 nm und 157 nm Wellenlänge bekannt. Beispiele sind u.a. in US 4 370 026 A und EP 0 747 772 A beschrieben.

Daneben betrifft sie eine Projektionsbelichtungsanlage nach Anspruch 7.

Vorgesehen ist die Verwendung eines Pseudo-Depolarisators in einem derartigen Beleuchtungssystem. Der Begriff Pseudo-Depolarisator verdeutlicht, daß diese Elemente die Polarisation nicht wirklich aufheben, sondern nur über den Querschnitt des Lichtbündels unterschiedliche Polarisationsänderungen bewirken, so daß im räumlichen Mittel keine Vorzugsrichtung der Polarisation mehr existiert.

Aus der Literatur sind verschiedene Pseudo-Depolarisatoren bekannt:

Der Hanle-Depolarisator, verbunden mit einem Kompensationskeil, wird z.B. von der Firma Bernhard Halle Nachfolger GmbH als optisches Experimentalelement angeboten.

Die DD 281 011 A1 beschreibt einen Depolarisator aus einem linear doppelbrechenden Keil und einem zirkular doppelbrechenden zweiten Keil zur Anwendung im UV-Gebiet für Meßgeräte (Spektrographen).

In Fuyun Xu, SPIE Vol. 1752 (1992), 307-310 sind verschiedene Quarz-Depolarisatoren einschließlich einer Anordnung von zwei Keilen mit gekreuzten optischen Achsen beschrieben.

Maßnahmen zur Überlagerung der bei diesen Elementen entstehenden Polarisationsverteilung - geometrisch nebeneinander alle Polarisationsrichtungen - sind jeweils nicht angegeben, es wird wohl davon ausgegangen, daß bei den Meßgeräten ein flächenhafter Detektor eine Integration bewirkt.

Bei der Mikrolithographie ist die Verwendung von unpolarisiertem Licht vorteilhaft, um eine richtungsunabhängige Strukturübertragung zu erreichen. Bei Mikrolithographiesystemen mit Wellenlängen unter 300 nm werden als Lichtquellen jedoch vorzugsweise linear polarisierte Excimer-Laser eingesetzt. Diese sind für die Wellenlängen 248 nm, 193 nm und 157 nm verfügbar.

Zur Erzeugung von Licht ohne Polarisationsvorzugsrichtung ist die Verwendung einer λ/4-Platte bekannt, die zirkular polarisiertes Licht erzeugt. Die Anforderungen an die Verzögerungstoleranz sind dabei sehr eng; beispielsweise verursacht ein Verzögerungsfehler von λ/100 noch eine Restpolarisation von 6%. Die Herstellung von Verzögerungsplatten mit solch engen Toleranzen ist bei den kurzen Wellenlängen aufwendig und dementsprechend kostspielig. Zudem kann die enge Toleranz nur über einen kleinen Temperaturbereich eingehalten werden.

Die der Erfindung zugrunde liegende Aufgabe ist die technisch einfache und kostengünstige Erzeugung von Licht ohne Polarisationsvorzugsrichtung in der Beleuchtungsebene von Beleuchtungssystemen der Mikrolithographie nach dem Oberbegriff des Anspruches 1. Erfindungsgemäß wird die Aufgabe durch die kennzeichnenden Merkmale des Anspruchs 1 gelöst. Es wird also an Stelle einer Verzögerungsplatte mit sehr engen Toleranzen ein Verzögerungselement mit lokal definiert unterschiedlichen Verzögerungen verwendet (Pseudo-Depolarisator) und durch lichtmischende Komponenten der nachfolgenden Optik im ganzen ausgeleuchteten Feld gleichmäßig unpolarisiertes Licht erzeugt. Die Variation der Dicke kann dabei über ein beliebiges, auch nicht ganzzahliges, Vielfaches der Emissionswellenlänge erfolgen. Die Erzeugung von unpolarisiertem Licht hat den weiteren Vorteil gegenüber zirkular polarisiertem Licht, daß im System nachfolgende, unbeabsichtigt polarisationsändernde Komponenten keine Rückwandlung des Polarisationszustands in ungünstiges elliptisch polarisiertes Licht verursachen können. Dies gilt im besonderen wieder bei sehr kurzen Wellenlängen.

Die Unteransprüche 2 bis 6 geben vorteilhafte Weiterbildungen an. Nach den Ansprüchen 2 und 3 ist das depolarisierende Element ein Keil, insbesondere ein Hanle-Depolarisator. Alternativ könnte z.B. auch eine Linse aus doppelbrechendem Material eingesetzt werden. In der Praxis wichtig ist die Maßnahme nach Anspruch 4, womit insbesondere ein Abknicken der optischen Achse und damit Komplikationen im Fassungsaufbau vermieden werden.

Anspruch 5 ist besonders in Verbindung mit Anspruch 4 optimal, da die refraktive Kompensation mit gesteigerter Depolarisation verbunden wird.

Anspruch 6 sieht zwei Lichtmischsysteme an zwei zueinander optisch konjugierten Ebenen vor und stellt so die Durchmischung und Depolarisation an jeder Stelle im weiteren Strahlengang sicher.

Die erfindungsgemäße Projektionsbelichtungsanlage nach Anspruch 7 hat ein Beleuchtungssystem mit Depolarisator nach einem der vorangehenden Ansprüche. Ansprüche 8 und 9 geben die bevorzugt damit zu kombinierenden Objektivtypen - rein refraktiv bzw. katadioptrisch - an.

Beispiele für diese Objektivtypen finden sich in US 5,260,832, DE 196 39 586 und US 5,691,802.

Näher erläutert wird die Erfindung anhand der Zeichnungen.

Im folgenden zeigen schematisch:
- Figur 1: eine schwach keilförmige Verzögerungsplatte als Depolarisator im Laserstrahl mit nachfolgender Lichtmischung durch eine Vielzahl nebeneinander angeordneter kleiner Linsenelemente;
- Figur 2: eine andere Ausführung des Verzögerungselements als Doppelkeil-Depolarisator;
- Figur 3: einen Einfachkeil-Depolarisator mit nachfolgender Lichtmischung durch zwei, jeweils eine Vielzahl nebeneinander angeordneter kleiner Linsenelemente enthaltende, Lichtmischelemente in zwei optisch konjugierten Ebenen zur Erzeugung von unpolarisiertem Licht an beliebigen Orten im optischen System;
- Figur 4: eine erfindungsgemäße Projektionsbelichtungsanlage.

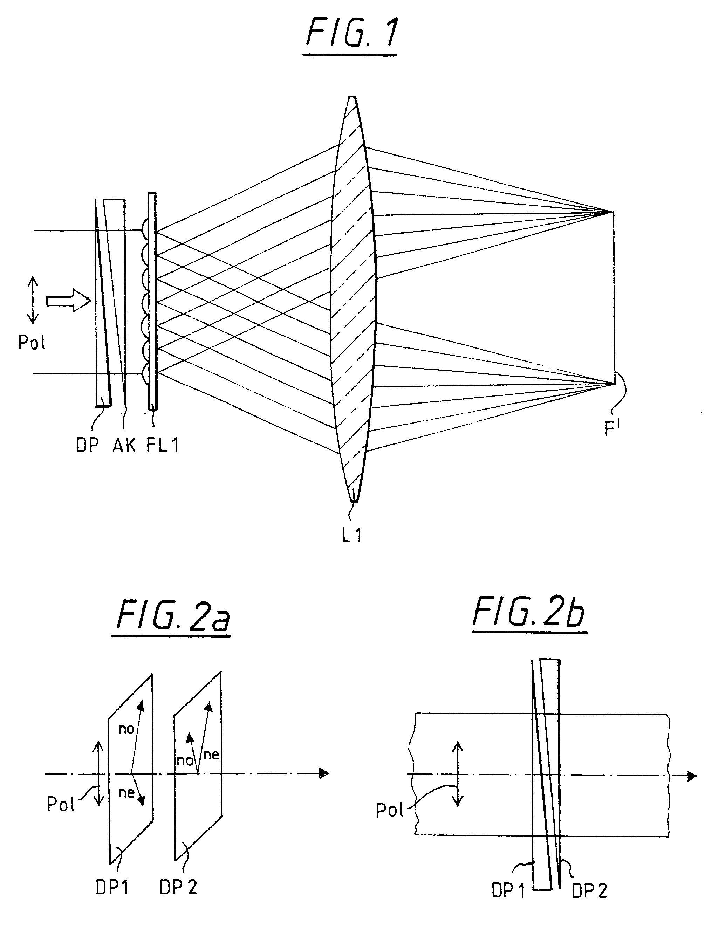

Zu Figur 1:
Der hier verwendete Pseudo-Depolarisator DP besteht aus einer Quarzplatte oder anderem doppelbrechendem Material und besitzt die Form eines flachen Keils. Der Kristall ist so geschnitten, daß Licht, das den Keil durchdringt, eine doppelbrechende Wirkung erfährt. Die optischen Achsen sind unter 45° zur Polarisationsrichtung des Lichts orientiert.

Das austretende Lichtbündel besitzt dann einen entlang der Keilrichtung sich stetig ändernden Polarisationszustand, der von linear polarisiert über zirkular polarisiert in um 90° gedreht linear polarisiert und entgegengesetzt zirkular polarisiert übergeht, und so weiter. Die lokal unterschiedlichen Polarisationszustände werden durch die nachfolgende "Fly's eye"-Linse FL1 und die dahinter befindliche Sammellinse L1 in der hinteren Brennebene F' von L1 vollständig überlagert.

Die Steigung des Keils ist vorzugsweise so zu wählen, daß über die Länge des Keils mehrere Ordnungen an optischer Verzögerung erreicht werden. Dann ist die Depolarisationswirkung nur noch gering von der Größe (Durchmesser) des Lichtbündels abhängig. Eine optimale Wirkung wird erreicht, wenn die Größe des Lichtbündels gerade einem Vielfachen der Strecke auf der Keilplatte entspricht, über die sich die Verzögerung um eine Wellenlänge ändert. Das Licht ist in diesem Fall an jedem Ort in der Ebene F' vollständig depolarisiert. Der maximal auftretende Restpolarisationsgrad nimmt mit zunehmender Anzahl von Verzögerungsordnungen rasch ab. Beträgt die Verzögerungsänderung über die Größe des Lichtbündels beispielsweise mehr als 4 Wellenlängen, so ist der maximal vorkommende Restpolarisationsgrad < 4%, unabhängig von der genauen Größe des Lichtbündels.

Ein im Strahlengang auf den Keildepolarisator folgender Keil AK aus geeignetem, optisch homogenem transmittivem Material dient zum Ausgleich der Ablenkung des Lichtbündels durch die Brechung am Keilwinkel des Depolarisators DP. Der Keilwinkel des Ausgleichskeils AK ist so zu wählen, daß unter Berücksichtigung des mittleren Brechungsindexunterschieds beider Materialien die Ablenkwirkung des Depolarisators DP gerade kompensiert wird.

Der Keil ist die einfachste Form eines optischen Elements mit unterschiedlicher Dicke. Andere Formen, z.B. Stufenformen oder Linsenformen, sind jedoch grundsätzlich auch geeignet.

Die gewünschte Depolarisation wird durch die erfindungsgemäß kombinierte Überlagerung der räumlich getrennten unterschiedlichen Polarisationszustände erreicht.

Statt des Einfachkeil-Pseudo-Depolarisators können auch andere Ausführungen von Pseudo-Depolarisatoren eingesetzt werden, wie sie z.B. aus DD 281 011 A1 oder Fuyun Xu, am angegebenen Ort, bekannt sind. Besonders vorteilhaft ist die Verwendung eines Doppelkeil-Pseudo-Depolarisators. Bei diesem erfolgt im Mittel keine Lichtablenkung durch Brechung und die Anzahl der Verzögerungsordnungen verdoppelt sich.

Figur 2 zeigt schematisch die Orientierung von Lichtrichtung L, Polarisationsrichtung Pol und optischen Achsen nₒ, nₑ der doppelbrechenden Keilplatten DP1, DP2. Figur 2b zeigt den Strahlengang in Seitenansicht.

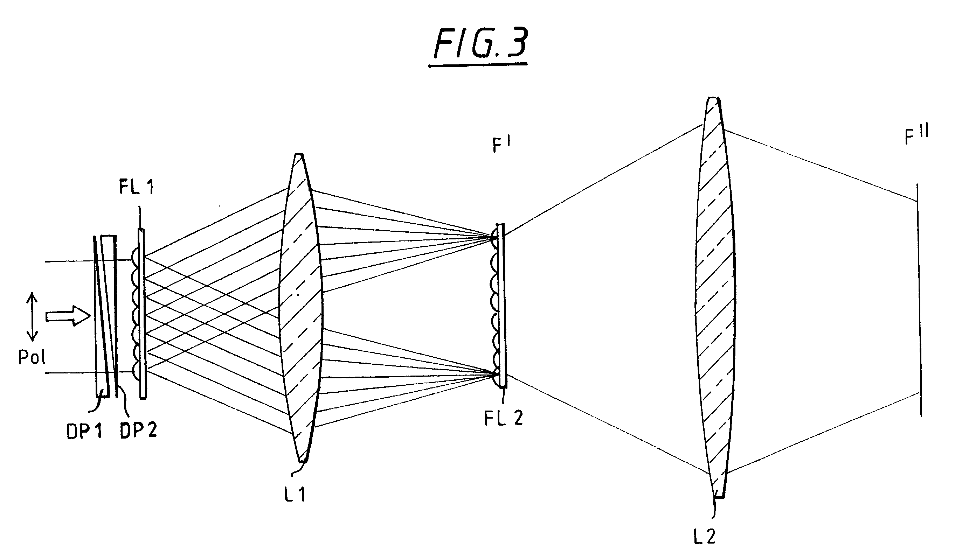

Zu Figur 3:
Durch den in Figur 1 bereits geschilderten Teil DK, AK, FL1, L1 wird nur in der hinteren Brennebene F' der Sammellinse L1 optimale Depolarisation erreicht. Durch Einbringen einer zweiten "Fly's-eye"-Linse FL2 in die Ebene F' und eine Sammellinse L2 im Abstand ihrer Brennweite F2 dahinter, läßt sich auch für die zu F' konjugierte Ebene F'' optimale Depolarisation erreichen, und damit auch in jeder anderen Ebene des Systems.

Statt der "Fly's-eye"-Linse FL 1, FL2 und der Sammellinse L1, L2 können auch andere lichtmischende Systeme eingesetzt werden (z.B. Glasstab).

Die "Fly's-eye"-Linsen FL1 und FL2 können als Rasterlinsen oder Wabenlinsen in bekannter Weise diskret aufgebaut werden, vgl. EP 0 401 608 B1 (89022 P), oder auch als Wabenplatten mit Mikrostrukturtechnik, auch als binäre Optik, Fresnel-Array usw. ausgebildet werden. Als Wabenkondensoren sind derartige Bauteile in Beleuchtungssystemen der Mikrolithographie gebräuchlich.

Sinnvoller Ort für den Pseudo-Depolarisator ist sicherlich am Anfang des optischen Systems im kollimierten aber schon aufgeweiteten Laserstrahl, damit alle Komponenten von der Depolarisation profitieren. Es wäre aber auch möglich, den Pseudo-Depolarisator an irgendeine andere Stelle, z.B. vor den Glasstab zu setzen. Dahinter muß noch eine vollständige Lichtmischung erfolgen.

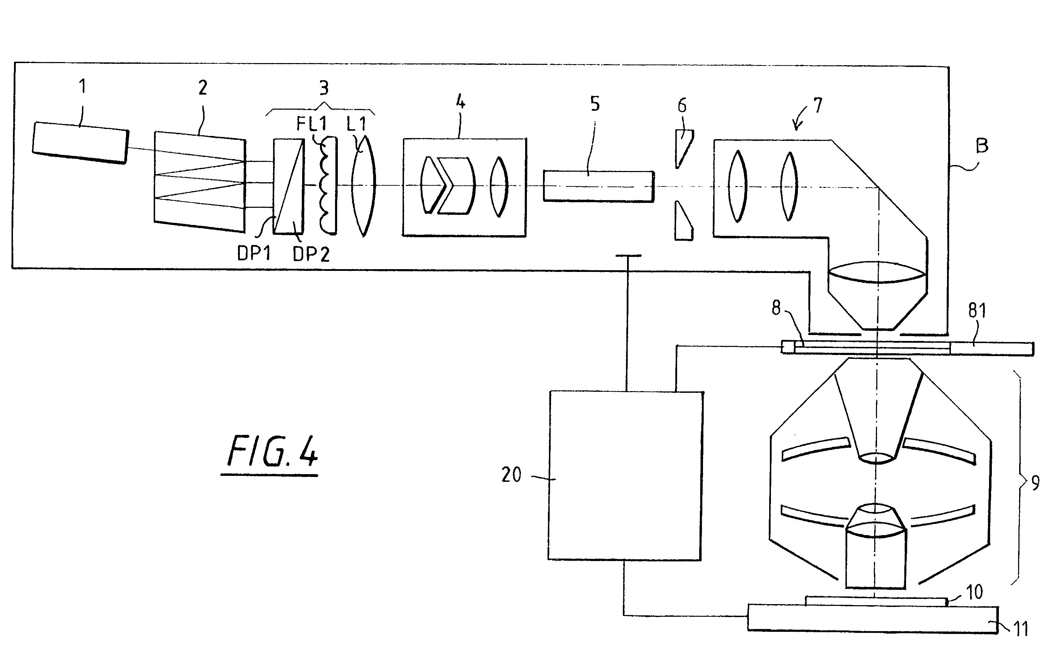

Figur 4 zeigt dazu ein Beispiel einer erfindungsgemäßen Projektionsbelichtungsanlage.

B ist das Beleuchtungssystem, enthaltend:
- einen Excimer-Laser 1, für 248 nm, 193 nm oder 157 nm, enthaltend in der Regel Mittel zur Einengung der Bandbreite wie Injection-locking, Etalon, Gitter;
- ein Strahlaufweitungssystem, das aus dem schmalen Rechteckqüerschnitt eine breitere, quadratische oder optimal runde Form erzeugt, z.B. mit einem zugleich kohärenzreduzierenden Spiegelkasten nach EP 0 747 772 A (95023 P) oder DE 41 24 311 A (89022 P) oder einem Teleskopsystem anamorphotischer Bauart, bzw. mit Kombinationen davon;
- ein Pseudo-Depolarisator 3 mit zwei Keilplatten DP1 und DP2, Rasterlinsenplatte FL1 und Sammellinse L1 gemäß obenstehender Beschreibung Figur 1 bis 3;
- optional eine Zoom-Axicon-Gruppe, wie aus EP 0 747 772 A (95023 P) bekannt, zur Einstellung der Beleuchtungsart;
- ein Glasstab 5 als Lichtmischelement, auch in der zu Figur 3 beschriebenen Funktion;
- ein Retikel-Maskier-System (REMA) 6, eine verstellbare Blende zur Festlegung des auf der Maske (Retikel, 8) ausgeleuchteten Bereichs (Scanschlitz oder bei Steppern einzelner Chip oder dergleichen);
- ein REMA-Objektiv 7 (vgl. DE 196 53 983 A (96033 P) welches das Retikel-Maskier-System 6 scharf auf die Maske 8 abbildet und für homogene telezentrische Beleuchtung sorgt;
- bedarfsweise nicht dargestellte Blenden, Verlaufsfilter, diffraktive optische Elemente und dergleichen, im Bereich der Baugruppen 1 bis 7, z.B. zur Einstellung von Quadrupol-Beleuchtung, Uniformity-Korrektur usw..

Weiter enthält die Projektionsbelichtungsanlage:
- die Maske 8 (Retikel) mit der abzubildenden Struktur auf einem Haltesystem 81 zur Positionierung und Verschiebung im Step-and-Repeat oder Scanning-Verfahren;
- das Projektionsobjektiv 9, hier schematisch dargestellt als katadioptrisches Reduktionsobjektiv koaxialer Bauart nach DE 196 39 586 A (96034 P);
- das Objekt (Wafer) 10, das strukturiert belichtet wird, auf einem Objekttisch (Wafer-chuck) 11, der ähnlich dem Haltesystem 81 zur genauen Positionierung (Autofokus usw.) und zur Verschiebung in Step-and-Repeat oder Scanning dient.
- Die ganze Anlage wird von einem Rechnersystem 20 in bekannter Weise gesteuert und geregelt, in Anpassung an die Strukturen und Eigenschaften der jeweils abzubildenden Maske 8.

Natürlich kann dieser beispielhafte Aufbau einer Projektionsbelichtungsanlage der Mikrolithographie in vielfältiger Weise abgewandelt werden. Erfindungsgemäßes Kernstück ist immer mindestens ein doppelbrechendes optisches Element mit über den Querschnitt variierender Dicke mit nachgeordnetem Mischelement.

Dabei hat der Hanle-Depolarisator den Vorteil, bei einfacher Form auch sehr kurz in Lichtrichtung zu sein, im Unterschied etwa zum auch brauchbaren Cornu-Depolarisator.

## Patentansprüche

1. Beleuchtungssystem der Mikrolithographie mit
- einem Excimer-Laser (1) mit einer Emissionswellenlänge
- einem Strahlaufweitungssystem (2)
- einem Lichtmischsystem (5)
- einer Beleuchtungsebene,
wobei,
- ein optisches Element (DP) aus doppelbrechendem Material in einem Lichtbündelquerschnitt angeordnet ist,
-- dessen Dicke über den Lichtbündelquerschnitt um ein Vielfaches der Emissionswellenlänge variiert
-- und dem optischen Element mindestens ein Lichtmischsystem (FL1, L1, 5) nachgeordnet ist,
**dadurch gekennzeichnet, daß**
- das optische Element (DP) derart doppelbrechend ist und das optische Element (DP) und das Lichtmischsystem (FL1, L1, 5) derart angeordnet sind, daß dadurch Licht ohne Polarisationsvorzugsrichtung in der Beleuchtungsebene erzeugt wird.

2. Beleuchtungssystem nach Anspruch 1, weiter **dadurch gekennzeichnet, daß** das optische Element (DP) ein Keil ist.

3. Beleuchtungssystem nach Anspruch 2, weiter **dadurch gekennzeichnet, daß** das optische Element (DP) ein Hanle-Depolarisator ist.

4. Beleuchtungssystem nach einem der Ansprüche 1-3, weiter **dadurch gekennzeichnet, daß** ein zweites optisches Element (DP, AK) die mittlere refraktive Wirkung des optischen Elements aus doppelbrechendem Material aufhebt.

5. Beleuchtungssystem nach mindestens einem der Ansprüche 1-4, weiter **dadurch gekennzeichnet, daß** ein weiteres optisches Element (DP2) aus doppelbrechendem Material mit zirkularer Doppelbrechung oder mit einer die Achse der Doppelbrechung des ersten optischen Elements (DP1) Kreuzenden Achse der Doppelbrechung vorgesehen ist.

6. Beleuchtungssystem nach mindestens einem der Ansprüche 1-5, weiter **dadurch gekennzeichnet, daß** je ein Lichtmischsystem (FL1, L1, FL2, L2, 5) in zwei zueinander konjugierten Ebenen angeordnet sind, insbesondere in einer zu der Beleuchtungsebene äquivalenten und in einer dazu konjugierten Ebene.

7. Projektionsbelichtungsanlage der Mikrolithographie mit
- einem Beleuchtungssystem (B)
- einer Maske (8) auf einem Haltesystem (81)
- einem Projektionsobjektiv (9)
- einem Belichtungsobjekt (10) auf einem Trägersystem (11)
- einem Steuer- und Regelsystem (20),
wobei das Beleuchtungssystem (B) nach mindestens einem der Ansprüche 1-6 ausgeführt ist.

8. Projektionsbelichtungsanlage der Mikrolithographie nach Anspruch 7, wobei das Projektionsobjektiv refraktiv ist.

9. Projektionsbelichtungsanlage der Mikrolithographie nach Anspruch 7, wobei das Projektionsobjektiv (9) katadioptrisch ist, insbesondere von achssymmetrischer Bauart mit zentraler Abschattung oder vom Typ des abgewandelten Schupmann-Achromaten.

## Claims

1. Illuminating system in microlithography, having
- an excimer laser (1) with an emission wavelength,
- a beam expanding system (2),
- a light mixing system (5), and
- an illumination plane,
wherein
- an optical element (DP) made from birefringent material is arranged in a light bundle cross section,
-- of which the thickness varies over the light bundle cross section by a multiple of the emission wavelength,
-- and at least one light mixing system (FL1, L1, 5) is arranged downstream of the optical element,
**characterized in that**
- the optical element (DP) is birefringent in such a way, and the optical element (DP) and the light mixing system (FL1, L1, 5) are arranged in such a way that as a result light is produced without a privileged polarizing direction in the illumination plane.

2. Illuminating system according to Claim 1, further **characterized in that** the optical element (DP) is a wedge.

3. Illuminating system according to Claim 2, further **characterized in that** the optical element (DP) is a Hanle depolarizer.

4. Illuminating system according to one of Claims 1-3, further **characterized in that** a second optical element (DP, AK) cancels the mean refractive effect of the optical element made from birefringent material.

5. Illuminating system according to at least one of Claims 1-4, further **characterized in that** provision is made of a further optical element (DP2) made from birefringent material with circular birefringence, or with an axis of birefringence crossing the axis of birefringence of the first optical element (DP1).

6. Illuminating system according to at least one of Claims 1-5, further **characterized in that** one light mixing system (FL1, L1, FL2, L2, 5) each are arranged in two mutually conjugate planes, in particular in a plane equivalent to the illumination plane and in a plane conjugate thereto.

7. Projection exposure machine in microlithography, having
- an illuminating system (B),
- a mask (8) on a holding system (81),
- a projection lens (9),
- an exposure object (10) on a carrier system (11), and
- a control and regulation system (20),
in which the illuminating system (B) is designed according to at least one of Claims 1-6.

8. Projection exposure machine in microlithography according to Claim 7, in which the projection lens is refractive.

9. Projection exposure machine in micro lithography according to Claim 7, in which the projection lens (9) is catadioptric, in particular has an axially symmetrical design with central shading, or is of the type of the modified Schupmann achromat.

## Revendications

1. Système d'éclairage en microlithographie, comprenant :
- un laser à excimère (1) ayant une longueur d'onde d'émission,
- un système d'élargissement de faisceau (2),
- un système de mixage de lumière (5),
- un plan d'éclairage,
dans lequel :
- est aménagé dans une section transversale du faisceau lumineux un élément optique (DP) constitué d'un matériau biréfringent,
- dont l'épaisseur varie sur la section transversale du faisceau lumineux d'un multiple de la longueur d'onde d'émission, et
- au moins un système de mixage de lumière (FL1, L1, 5) est aménagé en aval de l'élément optique,
**caractérisé en ce que** :
- l'élément optique (DP) est biréfringent et l'élément optique (DP) et le système de mixage de lumière (FL1, L1, 5) sont aménagés en sorte que de la lumière soit ainsi produite dans le plan d'éclairage sans direction de polarisation préférentielle.

2. Système d'éclairage selon la revendication 1, **caractérisé en outre en ce que** l'élément optique (DP) est un coin.

3. Système d'éclairage selon la revendication 2, **caractérisé en outre en ce que** l'élément optique (DP) est un dépolarisateur de Hanle.

4. Système d'éclairage selon l'une quelconque des revendications 1-3, **caractérisé en outre en ce qu'**un second élément optique (DP, AK) supprime l'action réfringente médiane de l'élément optique constitué d'un matériau biréfringent.

5. Système d'éclairage selon l'une quelconque des revendications 1-4, **caractérisé en outre en ce qu'**un autre élément optique (DP2) constitué d'un matériau biréfringent est pourvu d'une biréfringence circulaire ou d'un axe de biréfringence croisant l'axe de biréfringence du premier élément optique (DP1).

6. Système d'éclairage selon l'une quelconque des revendications 1-5, **caractérisé en outre en ce qu'**un système de mixage de lumière (FL1, L1, FL2, L2, 5) est aménagé respectivement dans deux plans mutuellement conjugués, en particulier dans un plan équivalent au plan d'éclairage et conjugué par rapport à celui-ci.

7. Installation d'exposition pour projection en microlithographie, comprenant :
- un système d'éclairage (B),
- un masque (8) sur un système de maintien (81),
- un objectif de projection (9),
- un objet à exposer (10) sur un système support (11),
- un système de commande et de réglage (20)
dans laquelle le système d'éclairage (B) est réalisé selon au moins l'une quelconque des revendications 1-6.

8. Installation d'exposition pour projection en microlithographie selon la revendication 7, dans laquelle l'objectif de projection est réfringent.

9. Installation d'exposition pour projection en microlithographie selon la revendication 7, dans laquelle l'objectif de projection (9) est catadioptrique, en particulier d'un type à symétrie axiale avec obscurcissement central ou d'un type d'objectif achromatique modifié de Schupmann.
